# EUROPÄISCHE PATENTANMELDUNG

(11) **EP 2 355 353 A1**
(43) Veröffentlichungstag der Anmeldung: **10.08.2011**
(21) Anmeldenummer: 10152738.0
(22) Anmeldetag: 05.02.2010
(51) Int. Cl.: H03K 17/082, H03K 17/687, H03K 17/567, H03K 17/13

(54) **Steuerverfahren zur Überstrom- und Kurzschlussstrombegrenzung eines Leistungsstellgliedes und zugehörige Einrichtung**

(71) Anmelder: SIEMENS AKTIENGESELLSCHAFT, 80333 München (DE)
(72) Erfinder: Roeder, Frank, 04317, Leipzig (DE); Fuchs, Enrico, 08141, Reinsdorf (DE)

(57) **Zusammenfassung**

Erfindungsgemäß werden ein Steuerverfahren zum Schutz eines Leistungsstellgliedes gegenüber Überströmen und Kurzschlussströmen und eine zugehörige Einrichtung (1) vorgeschlagen. Dabei sind zwei IGBT's (3)(Insulated-Gate Bipolar Transistor) als Leistungsstellglied zu einem Verbraucher (2) derart in Reihe geschaltet, dass eine Halbwellensteuerung möglich ist, d.h. die volle Wechselspannung oder jede Spannungshalbwelle einzeln geschaltet werden kann. Die Kollektor-Emitterspannung wird von dem jeweils in der Spannungshalbwelle aktuell durchgeschalteten IGBT (3) durch eine Überwachungseinrichtung (6) überwacht. Der Stromfluss im Heizstrahler (2) wird durch Sperren des aktuell in der jeweiligen Spannungshalbwelle durchgeschalteten IGBT (3) bis zum Ende der Spannungshalbwelle unterbrochen, sobald dessen Kollektor-Emitterspannung aufgrund eines Überstroms oder Kurzschlussstroms einen vorgegebenen Schwellwert überschreitet. Hierzu nimmt eine zur Ansteuerung der beiden IGBT's (3) dienende Steuereinrichtung (7) bei Überschreiten des vorgegebenen Schwellwertes das Ansteuersignal für die IGBT's (3) zur Stromunterbrechung bis zum Ende der Spannungshalbwelle zurück.

## Beschreibung

Die Erfindung betrifft eine Einrichtung zum Betrieb eines von einer Wechselspannung versorgten Verbrauchers, zu dem zwei Halbleiter als Leistungsstellglied derart in Reihe geschaltet sind, dass eine Halbwellensteuerung möglich ist, d.h. die volle Wechselspannung oder jede Spannungshalbwelle einzeln schaltbar ist.

Weiterhin betrifft die Erfindung ein Steuerverfahren zum Schutz eines zur Stromversorgung dienenden Leistungsstellgliedes gegenüber Überströmen und Kurzschlussströmen.

Derartige Einrichtungen sind aus der industriellen Praxis bekannt. Die Heizstrahler werden z.B. zur Realisierung von Verformungs- und Trocknungsprozessen in der Industrie verwendet und sind direkt über ein Leistungsstellglied an das Niederspannungsnetz angeschlossen. Die Leistungsstellglieder sind dabei in Thyristor- oder Triac-Technik ausgeführt. Im kalten Zustand, d.h. beim Einschalten, haben die Heizstrahler zunächst einen ohmschen Innenwiderstand von ca. 3 bis 5 Ohm. Während der Einschaltphase heizt sich der Heizstrahler auf und erreicht am Ende im heißen Zustand einen ohmschen Innenwiderstand von etwa 60 Ohm. Dementsprechend ist der Einschaltstrom um ein Vielfaches höher als der Betriebsstrom. Im System beim Kunden muss darauf geachtet werden, dass die Heizstrahler zeitversetzt eingeschaltet werden, da es sonst im Gesamtsystem zu einem Überstrom kommt. Zurzeit sind Anlagen mit 350 bis 500 Heizstrahlern bekannt. Derartige Überströme erfordern, dass das Leistungsstellglied nicht nur für den einfachen Betriebstrom, sondern insbesondere für den hohen Einschaltstrom ausgelegt werden muss. Eine entsprechende Überdimensionierung des Leistungsstellgliedes ist auch aufgrund der Forderung nach Kurzschlussfestigkeit notwendig und mit hohen Kosten verbunden. Diese Kurzschlussfestigkeit wurde bisher mit Schmelzsicherungen erreicht.

Der Erfindung liegt daher die Aufgabe zugrunde, eine Einrichtung und ein Steuerverfahren der oben genannten Art vorzuschlagen, wobei , Überströme begrenzt werden und eine Überdimensionierung des Leistungsstellgliedes vermieden wird.

Die das Steuerverfahren betreffende Aufgabe wird mit den Merkmalen nach Anspruch 1 gelöst.

Zum Verbraucher sind zwei IGBT's (Insulated-Gate Bipolar Transistor) als Leistungsstellglied derart in Reihe geschaltet, dass eine Halbwellensteuerung möglich ist, d.h. die volle Wechselspannung oder jede Spannungshalbwelle kann einzeln geschaltet werden. Das Steuerverfahren weist folgende Schritte auf:
a) Die Kollektor-Emitterspannung von dem jeweils in der Spannungshalbwelle aktuell durchgeschalteten IGBT wird überwacht und
b) der Stromfluss im Verbraucher wird durch Sperren des aktuell in der jeweiligen Spannungshalbwelle durchgeschalteten IGBT bis zum Ende der Spannungshalbwelle unterbrochen, sobald dessen Kollektor-Emitterspannung aufgrund eines Überstroms oder Kurzschlussstroms einen vorgegebenen Schwellwert überschreitet.

Eine vorteilhafte Weiterbildung des Steuerverfahrens besteht, wenn gemäß Anspruch 2 die Nulldurchgänge der Wechselspannung detektiert werden und von diesem Zeitpunkt ausgehend für die jeweilige positive oder negative Spannungshalbwelle der eine oder andere der beiden IGBT's durchgeschaltet und die Diode des jeweils anderen IGBT in Durchlassrichtung geschaltet wird.

Die weitere die Einrichtung betreffende Aufgabe wird mit den Merkmalen nach Anspruch 3 gelöst.

Dabei sind die Halbleiter als IGBT's (Insulated-Gate Bipolar Transistor) ausgeführt und es ist eine Überwachungseinrichtung zur Überwachung der Kollektor-Emitterspannung von beiden IGBT's vorgesehen. Außerdem ist eine Steuereinrichtung zur Ansteuerung der beiden IGBT's vorhanden, die bei Überschreiten eines vorgegebenen Schwellwertes durch die Kollektor-Emitterspannung des jeweils für die positive oder negative Spannungshalbwelle aktuell durchgeschalteten IGBT das Ansteuersignal für die IGBT's zur Stromunterbrechung bis zum Ende der Spannungshalbwelle zurücknimmt.

Ein Ausführungsbeispiel der Erfindung wird im Folgenden anhand einer Zeichnung näher erläutert.

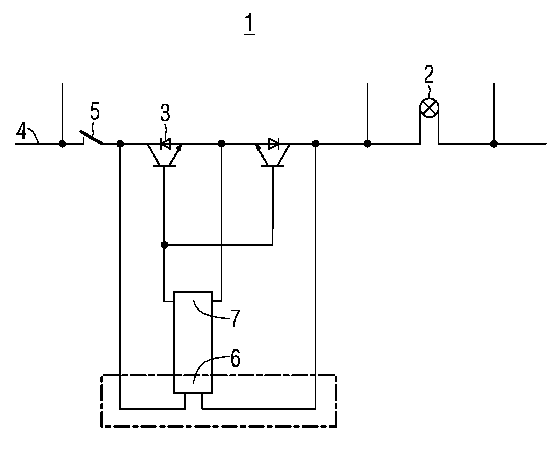

In der Zeichnung ist der Aufbau einer erfindungsgemäßen Einrichtung 1 mit einem von einer Wechselspannung versorgten Verbraucher 2 dargestellt. Zum Verbraucher, z.B. einem Heizstrahler 2, sind zwei IGBT's 3 (Insulated-Gate Bipolar Transistor) als Leistungsstellglied derart in Reihe geschaltet, dass eine Halbwellensteuerung möglich ist, d.h. die volle Wechselspannung oder jede Spannungshalbwelle einzeln schaltbar ist. Die Leitungsanschlüsse 4 dienen zum Anschluss an die Wechselspannung eines Niederspannungsnetzes. Zur Absicherung der Zuleitung sind zwei Leitungsschutzschalter 5 vorhanden. Weiterhin ist eine zur Überwachungseinrichtung 6 zur Überwachung der Kollektor-Emitterspannung von beiden IGBT's 3 und eine Steuereinrichtung 7 zur Ansteuerung der beiden IGBT's 3 vorgesehen. Letztere liefert ein gemeinsames Ansteuersignal für die beiden IGBT's 3. Bei Überschreiten eines vorgegebenen Schwellwertes durch die Kollektor-Emitterspannung des jeweils für die positive oder negative Spannungshalbwelle aktuell durchgeschalteten IGBT 3 nimmt die Steuereinrichtung 7 das Ansteuersignal für die IGBT's 3 zur Stromunterbrechung bis zum Ende der Spannungshalbwelle zurück.

Somit können keine Überströme auftreten, da die IGBT's 3 den Kurzschlussstrom selbst begrenzen.

Nach dem erfindungsgemäßen Steuerverfahren wird die Kollektor-Emitterspannung von dem jeweils in der Spannungshalbwelle aktuell durchgeschalteten IGBT 3 durch die Überwachungseinrichtung 6 überwacht. Der Stromfluss im Verbraucher 2 wird durch Sperren des aktuell in der jeweiligen Spannungshalbwelle durchgeschalteten IGBT 3 bis zum Ende der Spannungshalbwelle unterbrochen, sobald dessen Kollektor-Emitterspannung aufgrund eines Überstroms oder Kurzschlussstroms einen vorgegebenen Schwellwert überschreitet.

Bei dem Steuerverfahren werden die Nulldurchgänge der Wechselspannung detektiert und von diesem Zeitpunkt ausgehend wird für die jeweilige positive oder negative Spannungshalbwelle der eine oder andere der beiden IGBT's 3 durchgeschaltet und die Diode des anderen IGBT 3 in Durchlassrichtung geschaltet.

Die Überwachungseinrichtung 6 sowie die Steuereinrichtung 7 können gemeinsam in einem Mikroprozessor realisiert sein.

Jedem Heizstrahler 2 einer Anlage mit mehreren Heizstrahlern wird vorteilhafterweise eine Impulssperre zugeordnet, die der Mikroprozessor mit einem Low-Signal bedient, wodurch der Heizstrahler 2 deaktiviert wird.

Bei einem High-Signal werden die Impulse nicht gesperrt und der Verbraucher bzw. Heizstrahler 2 kann aktiviert werden.

Da bei dem vorliegenden Steuerverfahren und der zugehörigen Einrichtung die IGBT's den Kurzschlussstrom selbst begrenzen, erübrigt sich der Einsatz von Schmelzsicherungen zum Schutz der Halbleiter.

Das oben genannte Steuerverfahren und die zugehörige Einrichtung sind auch zum Betrieb von anderen Verbrauchern als einem Heizstrahler geeignet, um hier etwa auftretende Kurzschlussströme auf einfache Weise zu begrenzen und somit das Leistungsstellglied vor Zerstörung zu schützen.

Mit diesem Verfahren kann eine separate zusätzliche Strommessung, z.B. mittels Strommessshunt vermieden werden.

## Patentansprüche

1. Steuerverfahren zum Schutz eines zur Stromversorgung dienenden Leistungsstellgliedes gegenüber Überströmen und Kurzschlussströmen, wobei als Leistungsstellglied zwei IGBT's (3) (Insulated-Gate Bipolar Transistor) zu einem mit einer Wechselspannung versorgten Verbraucher (2) derart in Reihe geschaltet sind, dass eine Halbwellensteuerung möglich ist, d.h. die volle Wechselspannung oder jede Spannungshalbwelle einzeln geschaltet werden kann, mit folgenden Schritten:
a) Die Kollektor-Emitterspannung von dem jeweils in der Spannungshalbwelle aktuell durchgeschalteten IGBT (3) wird überwacht und
b) der Stromfluss im Verbraucher (2) wird durch Sperren des aktuell in der jeweiligen Spannungshalbwelle durchgeschalteten IGBT (3) bis zum Ende der Spannungshalbwelle unterbrochen, sobald dessen Kollektor-Emitterspannung aufgrund eines Überstroms oder Kurzschlussstroms einen vorgegebenen Schwellwert überschreitet.

2. Steuerverfahren nach Anspruch 1, **dadurch gekennzeichnet, dass** die Nulldurchgänge der Wechselspannung detektiert werden und von diesem Zeitpunkt ausgehend für die jeweilige positive oder negative Spannungshalbwelle der eine oder andere der beiden IGBT's (3) durchgeschaltet und die Diode des anderen IGBT in Durchlassrichtung geschaltet wird.

3. Einrichtung (1) zum Betrieb eines von einer Wechselspannung versorgten Verbrauchers (2), zu dem zwei Halbleiter als Leistungsstellglied derart in Reihe geschaltet sind, dass eine Halbwellensteuerung möglich ist, d.h. die volle Wechselspannung oder jede Spannungshalbwelle einzeln schaltbar ist, **dadurch gekennzeichnet, dass** die Halbleiter als IGBT's (3) ausgeführt sind, dass eine Überwachungseinrichtung (6) zur Überwachung der Kollektor-Emitterspannung von beiden IGBT's (3) vorgesehen ist und dass eine Steuereinrichtung (7) zur Ansteuerung der beiden IGBT's (3) vorhanden ist, die bei Überschreiten eines vorgegebenen Schwellwertes durch die Kollektor-Emitterspannung des jeweils für die positive oder negative Spannungshalbwelle aktuell durchgeschalteten IGBT (3) das Ansteuersignal für die IGBT's (3) zur Stromunterbrechung bis zum Ende der Spannungshalbwelle zurücknimmt.
